Europäisches Patentamt

European Patent Office

Office européen des brevets

(11) Publication number: **0 224 857 B1**

# EUROPEAN PATENT SPECIFICATION

(45) Date of publication of patent specification: **25.03.92**  (51) Int. Cl.⁵: **H01L 27/10, G11C 17/00**

(21) Application number: **86116367.3**

(22) Date of filing: **25.11.86**

(54) **Junction shortening-type semiconductor read-only memory.**

(30) Priority: **28.11.85 JP 267896/85**

(43) Date of publication of application:
**10.06.87 Bulletin 87/24**

(45) Publication of the grant of the patent:
**25.03.92 Bulletin 92/13**

(84) Designated Contracting States:
**DE FR GB**

(56) References cited:
**US-A- 4 287 569**

**PATENTS ABSTRACTS OF JAPAN, vol. 8, no. 131 (E-251)[1568], 19th June 1984; & JP-A-59 43 566**

**IDEM**

**IEEE TRANSACTIONS ON ELECTRON DEVICES, vol. ED-30, no. 12, December 1983, pages 1785-1791, IEEE, New York, US; T. FUKUSHIMA et al.: "An advanced SVG technology for 64K junction-shorting PROM's"**

(73) Proprietor: **FUJITSU LIMITED**
**1015, Kamikodanaka Nakahara-ku**
**Kawasaki-shi Kanagawa 211(JP)**

(72) Inventor: **Fukushima, Toshitaka**
**1604-442, Shiomidai Isogo-ku**
**Yokohama-shi Kanagawa, 235(JP)**

(74) Representative: **Schmidt-Evers, Jürgen, Dipl.-Ing. et al**
**Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10**
**W-8000 München 22(DE)**

## Description

### BACKGROUND OF THE INVENTION

#### Field of the Invention

The present invention relates to an improvement of a semiconductor read-only memory (referred to hereinafter as PROM) whose diode is written-in by shortening its junction. More particularly, the present invention relates to a structure of its memory cell achieving increased density of integration and increased speed of the operation.

### PRIOR ART DOCUMENTS

The US-A-4,287,569 discloses a semiconductor device having a plurality of memory cells located at a cross position of a plurality of bit lines and a plurality of word lines, the memory cell comprising a series circuit of an information storing element such as a diode or a fuse and a PNP type transistor. An N type epitaxial layer is used as a word line and the P type semiconductor substrate is used as a collector output line.

To improve the integration of a semiconductor memory device the JP-A-59-43566 discloses forming a buried layer of an isolation region, thereby substantially reducing the width of the buried layer to enhance the concentration of a current at the wiring time. An isolating region is formed in a structure that a dielectric material is buried in a deep groove formed on an Si substrate. Reactive ion etching is used, the groove is substantially vertically cut to substantially reduce the width of an $N^+$ type buried layer. The inside of the region becomes an element forming region, and two bipolar transistors are formed. Each transistor is formed of an emitter, a base and a collector in this order from the surface in a vertical shape in such a manner that the collector contact is made common.

#### Description of the Related Art

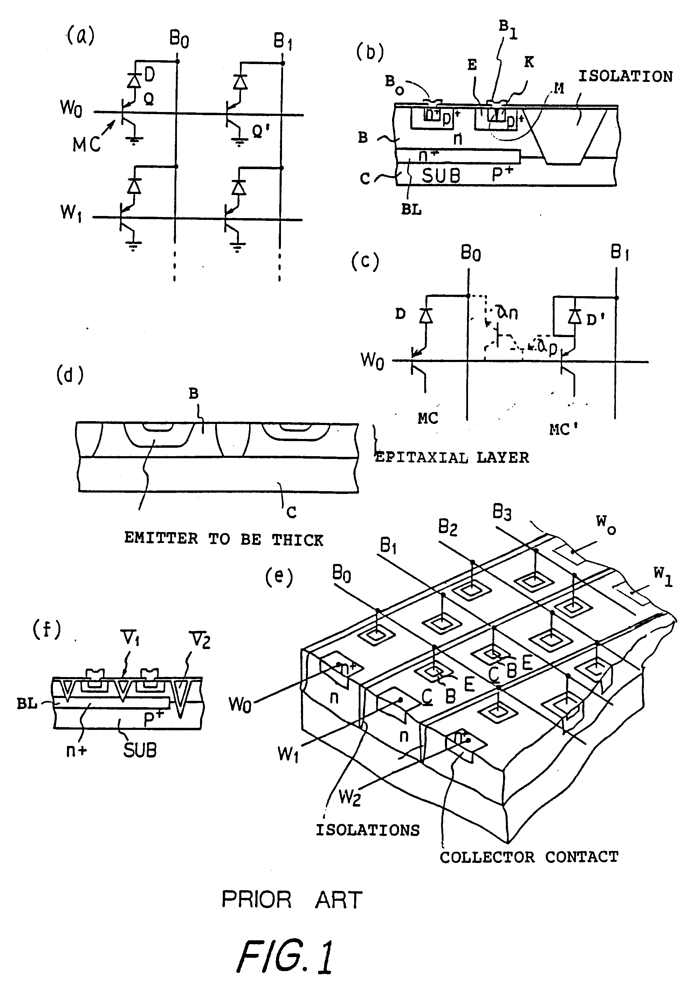

The principle of a typical PROM according to the above prior art of junction shorting type is schematically illustrated in FIGs. 1. The PROM of junction shorting type includes word lines $W_0$, $W_1$,..., bit lines $B_0$, $B_1$,..., and memory cells, each of which is connected to a cross point of one of the word lines and one of the bit lines. Each memory cell MC includes a series connection of a transistor Q and a diode D which is polarized so as to block a current flowing through the transistor. The cathode of the diode is connected to a bit line, and the base of the transistor is connected to a word line. The structure of the memory cell is schematically illustrated by the cross sectional view in FIG. 1(b).

The $n^+$ region K and the $p^+$ region E therebeneath form the cathode and the anode of the diode D respectively. And the same $p^+$ region E, the n region B and the substrate SUB form the emitter, the base and the collector of the pnp transistor Q respectively. For writing-in the cell, the pn junction of the diode is shorted by applying a voltage higher than the break down voltage of the reversely connected diode D and a current high enough to short the junction of the diode. The shorted cell MC' is indicated by a mark M in FIG. l(b). When a word line having a shorted diode connected thereto is selected, namelY addressed, by applying a low level L on the base of the transistor Q, the transistor becomes conductive to pull the connected bit line down to the low level, L. However, when the diode is not written-in, the diode is non-conductive, so the connected bit line is not pulled down keeping the high level H which is given by selecting the bit line connected to this cell, even if the transistor Q becomes conductive. Thus, an addressed bit line, being applied with H, can be readed-out the stored data "l" or "0" of the cell connected thereto, by detecting whether a current flows into the bit line or not.

Since the first PROMs of 256 and 5l2 bit are developed in l970, the memory capacity has been enhanced by the pace of four times per three years and now 64K bit integration is on production. And further increase of the integration capacity is still expected. Reviewing the history of the developments, at the early stage of the junction shorting type PROM, the gold diffused TTL technique was employed. Thenafter, the more precise lithography technique for the greater density integration, the washed emitter technique, and the mask self-alignment technique have been employed. In addition to these techniques, a technique for suppressing the parasitic thyristor effect caused by the increased density of the integration has been developed. These are reported by the inventor et al. in "An Advanced SVG Technology for 64K Junction-Shorting PROM's", IEEE Transactions on Electron Devices, Vol.ED-30, No.l2, Dec, l983.

The problems of this thyristor effect shall be further described in some detail. When one of the memory cells is already written-in and an adjacent memory cell thereto fabricated on a common epitaxial layer is not written-in yet, there is produced a parasitic pnpn element, namely a thyristor, between these two cells, as shown by the dotted lines in FIG. l(c). If this thyristor turns on, the selected bit line $B_1$ so being to be of H level is clamped to the unselected bit line $B_0$ having L level. At this state, any other memory cell on the bit line $B_1$ can not be written-in, because sufficient voltage to write-in the other cell is not available on the bit line $B_1$ any more. As widely known, a thyristor is composed of two transistors of npn and pnp, and the breakover voltage $V_{Bo}$ of the thyristor is decided by the following formula, where $V_{CB0}$ denotes the collector-base break down voltage of the parasitic npn transistor and $a_n$, $a_p$ denote the current amplification factors of the npn transistor and pnp transistor respectively, and n is a constant:

$$V_{B0} = V_{CB0}(l-a_n - a_p)^{l/n}$$

and the thyristor latches up at:

$$a_n + a_p \cong l$$

Consequently, in order to prevent the latching up the thyristor, $V_{B0}$ must be large, in other words, the current amplification factors $a_n$ and $a_p$ should be small. For this purpose, the $p^+$ layer, namely the base, of the parasitic npn transistor is made thick as shown in FIG. l(d), resulting in reduced $a_n$. Further more, this thick region attendantly raises the break down voltage of the transistor Q, at the same time. As another measure, the cells adjacent to each other may be located in staggered position, so as to reduce the facing peripheral length of the emitters to each other resulting in lowered current amplification factor of the parasitic transistor. These techniques have been contributing to increase the density of integration, namely to produce PROM of 256K to 8K bit. The size of the memory cell has shrunk from l820 micro m$^2$ to l260 micro m$^2$ (or micron $^2$).

However, as long as the gold diffused TTL process is employed, the following problems still remained unsolved:

(a) Because of segrigation problem of the gold, as well known, the epitaxial layer is required to be thick (7 micron m) and consequently, the deeply diffused $p^+$ thick base layer (2 micron) causes its lateral diffusion expanding wider, resulting in wider surface occupation area. Therefore, increasing the density of integration is limited.

(b) Control of gold-doping is difficult, because the larger the wafer size becomes, the larger the uncontrolable heat capacity becomes. So the diameter of the wafer can not be increased for better production efficiency.

(c) Gold particles in the diffused layer are easy to cause shorting emitter and collector junctions. Therefore, the base width of transistors can not be reduced, namely increase of the current amplification factor of the transistors is limited ($h_{FE}$:25 to l00). This means, there are limitations of reducing power consumption in the circuit as well as increasing the operation speed.

(d) The logic circuit must be of saturated type, so the switching speed is limited to increase.

In order to solve these problems, as widely known, the V-shaped isolation groove, or so-called SVG (a Shallow V-shaped Groove), which provides perfect separation of the elements by a relatively shallow groove, was invented, as shown by $V_1$ in FIG. l(f). This V-shaped groove reaches the upper side of the buried $n^+$ layer BL, namely a buried base lead, from the surface of the epitaxial layer, thus perfectly isolates the epitaxial layer of each memory cell. Some conduction may be existing through the buried n + layer BL, however the minority carriers in the epitaxial regions can not diffuse into the adjacent cell, because this $n^+$ region is highly doped to cause recombination of these carriers. $V_2$ indicates another isolation groove, which reaches the substrate SUB, thus completely isolating each cell block.

Introduction of this SVG technique allows to disuse the gold diffusion having many problems, thus the following advantages are achieved:

(a) The parasitic thyristor effect between adjacent cells are completely removed.

(b) The thin epitaxial layer (3 $\mu$m) as well as thin $p^+$ diffused base layer (0.7 $\mu$m) can be employed in the npn transistors of the peripheral circuits. Thus, the density of the integration can be increased.

(c) A wafer diameter can be increased for increasing production efficiency.

(d) The base width of the npn transistor of the peripheral circuit can be thin, so that the current amplification factor of the transistor can be made large ($h_{FE}$: 70 to 250), resulting in allowing the higher speed operation as well as the lower power consumption in the peripheral circuits.

(e) The Schottky diode-clamped TTL technique is employed in the peripheral circuits to increase the operation speed.

As described above, owing to the invention of the V-shaped groove, a PROM of 256 to 64K bit with the Schottky diode clamped TTL technique has been materialized. The area of the memory cell is reduced from 864 square micron to 252 square micron . The current status of the art are also reported by the inventor et al. in "A 40ns 64K bit Junction-Shorting PROM", IEEE Journal of Solid Sate Circuits, Vol sc-l9, No. 2, April l984.

However, problems are still remaining as hereinafter described. SVG isolation is formed by widely known anisotropic etching using a peculiar characteristics of (l00) crystal of silicon. As widely known, the relation between the width W on the mask of the lithography and the depth D of the groove is shown by the formula:

$$D = (l/2) W \tan 54° \cong 0.7 W$$

Therefore, when the epitaxial layer is 3 $\mu$m thick

and the upward diffusion of the $n^+$ buried layer is I micron thick, namely difference 2 $\mu$m is required for the depth so 3 $\mu$m for the width of the SVG are automatically determined. Thus no more reduction of the isolation width is possible. Further more, as widely known, in the V-shaped isolation, eaves (approximately I micron on each side) of silicon dioxide, so-called a bird beak, expand laterally along the surface. Therefore, margin area between the adjacent patterns is required, so a greater density integration is prevented.

The problems about the vertical (depth) direction are as follows. The isolation effect of the SVG becomes sure when the groove reaches the $n^+$ buried layer. So, the epitaxial layer is required to be thin, so that the groove width at the surface can be narrow. Therefore, the upward diffusion of the $n^+$ buried layer must be sufficiently controlled, but it is difficult. On the other hand, in order to keep reliability of writing-in the cell, the depth of the p + layer, namely the emitter of the pnp transistor Q, is generally required to be approximately I.2 $\mu$m thick. And, in order to secure more than 20V of the break down voltage between the base (n epitaxial layer) and the emitter during writing-in the cell, the width of the depletion is generally required approximately I $\mu$m Therefore, if the upward diffusion of the buried layer is I $\mu$m, the epitaxial layer is required to be at least 3 $\mu$m thick.

On the other hand, also in the peripheral circuit, such as X and Y address inverter X-ADD; Y-ADD, decoder/driver D/D, multiplexer MPX, and chip-enable CE, further increase of the operation speed, and increase of the integration density, and/or decrease of the power consumption must be achieved. For solving these problems, stray capacity in the circuits, particularly the stray capacity of the word line, must be reduced and performance of the transistors in the circuits must be graded up in order to ease the current load of the circuits. Explanation regarding the relations between these factors and the effects shall be given related to the later description of the preferred embodiments in detail.

## SUMMARY OF THE INVENTION

It is an object of the invention to provide a junction shorting type PROM having an increased density of integration as well as an increased speed of operation.

This object is solved by a junction-shortening type semi-conductor programmable read only memory device as defined in the appended claims.

In a structure of the memory cell of the junction shorting type PROM having a diode on a transistor both of which are connected in series and the cell is fabricated by the stack of diffused layers on a substrate, the present invention provides a memory cell which has no buried layer as a word line and is paired with an adjacent cell to form a cell block and the cell block is further isolated by an insulation region surrounding the cell block from an adjacent cell block. The structure in detail is as follows. Between the emitters as well as bases of the transistors of the paired cell but isolated from the emitter, a highly doped region made of an opposite conductivity to the substrate is provided reaching the substrate, so as to separate each base, namely to prevent the minority carriers in each base region from diffusing laterally into each other base region. This highly doped region, also as a base contact region, leads the paired bases commonly out to a corresponding word line fabricated upon the surface of the cells. The base contact region may be separated from each emitter region of the cell by a pair of isolation grooves filled with a dielectric material as deep as not reaching the substrate. The cell block is isolated from an adjacent cell block by a U-shaped isolation groove filled with a dielectric material reaching the substrate. The occupation area reduced by the U-shaped isolation groove reduces stray capacity of the wirings. Elimination of the buried base conductor also reduces stray capacity of the word lines etc., and further reduces the thickness of the epitaxial layer. Reduction of the thickness of the epitaxial layer increases current amplification factor of the transistors and also contributes to decrease the surface area of the periferal circuit. All these factors finally contribute to increase the density of integration, to increase the speed of operation and to decrease the power consumption, not only at the cell area but also at the peripheral circuits.

The above-mentioned features and advantages of the present invention, together with other objects and advantages, which will become apparent, will be more fully described hereinafter.

## BRIEF DESCRIPTION OF THE DRAWINGS

FIGs. I schematically illustrate the prior art PROM. n FIGs. I, (a) is a principal circuit diagram of a junction shorting type PROM, (b) is a cross sectional view of the memory cells, (c) schematically illustrates the parasitic thyristor between adjacent cells, (d) shows a cross sectional view of a cell to explain the thickness relation, (e) is a birds-eye view of the cells, and (f) schematically illustrates the SVG.

FIGs. 2 schematically illustrate the memory cells of the PROM according to the present invention. In FIG. 2, (a) is a birds-eye view of the memory cell, (b) shows a plan view of six cell blocks, and (c) is the circuit diagram of the two pairs of the memory cells.

FIG. 3 through 5 illustrate the sequential steps for fabricating the PROM according to the present invention.

FIG. 6 schematically illustrates the upward diffusion from the substrate to help the downward diffusiion of the highly doped region reach the substrate.

## DESCRIPTION OF THE PREFERRED EMBODIMENT

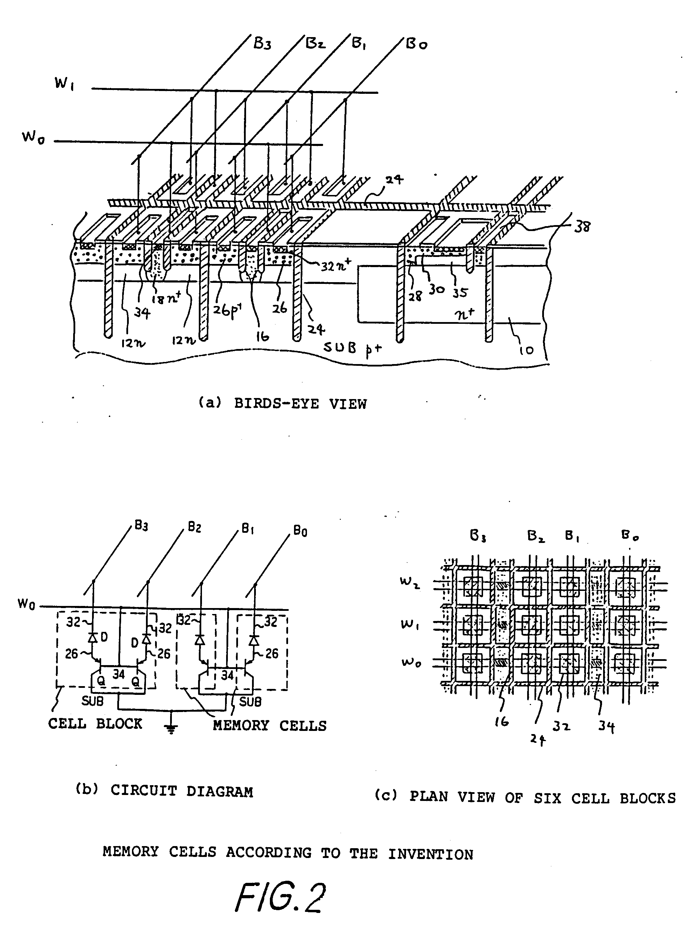

Referring now to FIGs. 2, the principal structure and the circuit diagram of the invention are shown. The $n^+$ region 32 and $p^+$ region 26 respectively form the cathode and the anode of the diode D of a cell. The same $p^+$ region 26, the n region 12, the highly doped $n^+$ region 18, and the substrate SUB respectively forms the emitter, the base, and the collector of the pnp transistor Q of the cell. Two of these cells adjacent to each other compose a pair, namely a cell block. The circumference of this cell block is isolated from its adjacent cell blocks by the U-shaped isolation regions 24. Each base region of paired transistors is separated by a highly doped diffusion region 18 which prevents the diffusion of the minority carriers (holes) into each other base region. This highly doped region 18 also acts as a base contact region which leads both of the base regions to the common base contact 34 provided on the top of the highly doped region 18. Word lines $W_0,..W_3$ are respectively connected to each corresponding common base contact 34. Bit lines $B_0,..B_3$ are respectively connected to each corresponding cathode region 32 of the diode D.

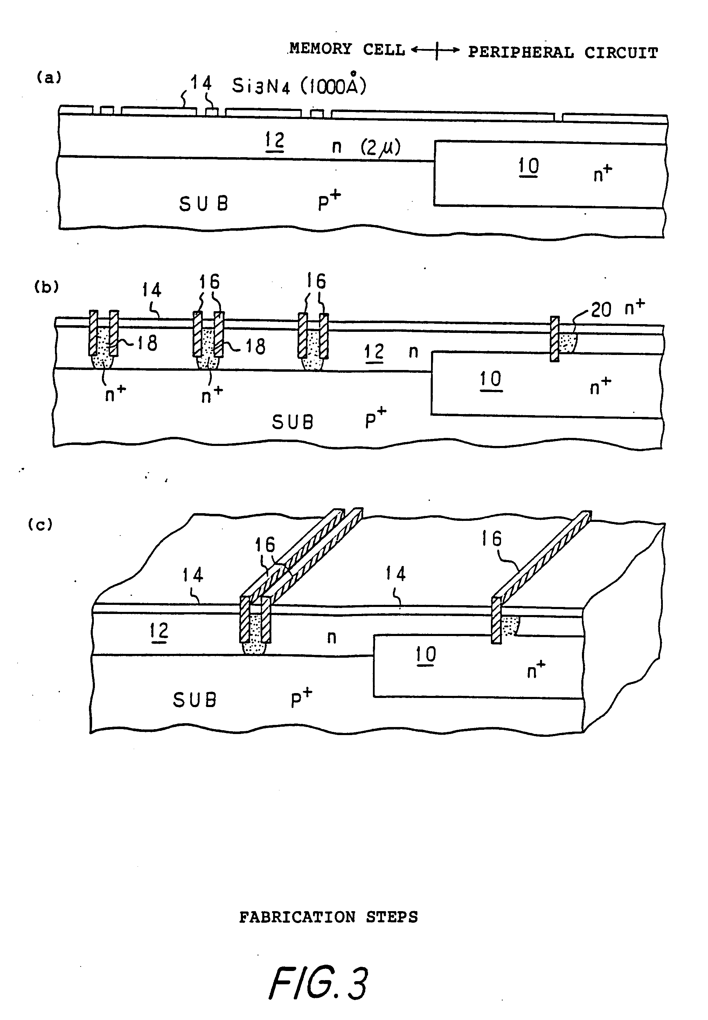

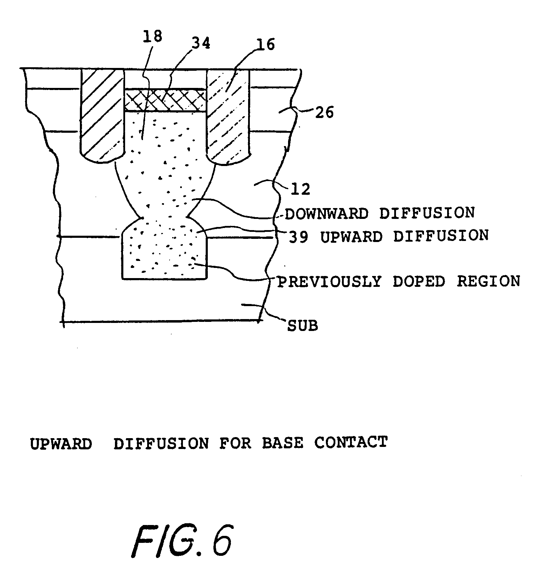

Referring to FIG. 3 through 5, the fabrication steps of the PROM according to the invention are successively illustrated. As shown in FIG. 3(a), according to a widely known technique used for a general bipolar IC (Integrated Circuit) fabrication process, the $n^+$ buried layer 10 is firstly formed on an area of the substrate SUB where the peripheral circuits are to be fabricated, namely excepting the area where the cells are to be fabricated. Next, an n epitaxial layer 12 is grown all over the substrate having the buried layer 10 as shown in FIG. 3(a) by a widely known method used for a general bipolar IC fabrication. Next, a silicon nitride film 14 of approximately 1000Å (1Å = 0.1nm) thick, for example, is formed upon the epitaxial layer 12 by a widely known method used for a general bipolar IC fabrication. The silicon nitride film is patterned as shown in the figure, by a widely known method used for a general bipolar IC fabrication. Next, the epitaxial layer below the opened window of the nitride film 14 is oxidized by the widely known local oxidization method used for a general bipolar IC fabrication, to form a pair of the isolation regions 16, each top of which is swelling out beyond the nitride

film 14 caused by the oxidization. This isolation region 16 is for preventing the lateral expansion of the $p^+$ diffusion layer 32 which is to be fabricated later as an emitter of the pnp transistor Q in the cell as well as the lateral expansion of the base contact 34 which is also to be fabricated later. The region 16 can be fabricated by not only the above-described local oxidization but also by the above-described SVG method. The depth of this isolating region 16 is deeper than the emitter region but shallower than the top of the substrate, so that the highly doped region 18 is isolated from the emitters but can contact the base regions. Next, a dopant, such as phosphorous or arsenic, is diffused into a particular part of the epitaxial layer 12 located between the paired isolation regions 16 to form the highly doped region 18, so high as $10^{19}$ $cm^{-3}$ of concentration measured at the surface, for example. The highly doped region 18 must be formed deep enough to reach the substrate SUB, so that the diffusion of the minority carriers (holes) in each paired cell from/to the other cell is completely prevented. The formation of this highly doped region 18 may be carried out not only by a widely known simple diffusion from the surface (downward diffusion) or the ion implantation but also by its combination with an additionally employed upward diffusion 39 (shown in FIG. 6) of an $n^+$ buried layer previously prepared on the particular portion where the highly doped region 18 is to reach on the substrate. In the case where the upward diffusion of the buried layer is employed, an attention must be, of cause, paid for the mask alignment of the upward diffusion 39, however, the alignment is easy because the width of the isolation region 16 is 2 $\mu$m and the accuracy of the alignment is below 2 $\mu$m without difficulty, so the downward diffusion and the upward diffusion will never fully deviate from each other. 20 denotes a highly doped $n^+$ region which acts as a collector contact connecting the buried layer 10 for a npn transistor in the peripheral circuit to the collector terminal 38. FIG. 3(c) illustrates the a birds-eye view of FIG. 3(b). The isolation regions 16 and the highly doped $n^+$ region 18, 20 are extended laterally along the surface of the epitaxial layer, so that the conduction between the elements are perfectly prevented.

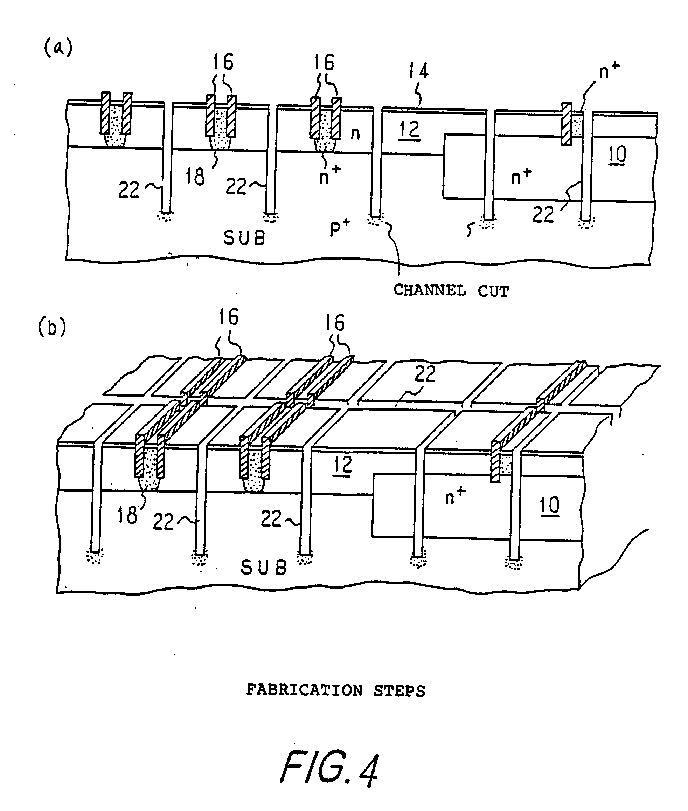

Next, in order to isolate each cell block including the pair of the memory cells, an U-shaped groove 22 is formed as narrow as 1.4 $\mu$m between each cell block by a widely known technique, such as dry etching, as shown in FIG. 4(a) and its birds-eye view FIG. 4(b). On forming the U-shaped groove 22, the delicate control of its depth is generally difficult in contrast with the case to form V-shaped groove where the depth D can be controlled by its width W at the surface by the above-described relation: $D = 0.7W$. However, in the embodiment of the present invention, the delicate depth control of the U-shaped groove 22 is not required, because the depth can be rather relaxed as long as the U-shaped groove isolates the cell blocks. Therefore, according to the present invention, it is easy to control the fabrication conditions. Into the bottom portion of the U-shaped groove 22, a $p^+$ dopant, such as boron, is diffused by an ion implantation method, for example, to cut an undesirable electrical channel formed along the outer surface of the groove, as widely known. And, the side walls in the U-shaped groove is oxidized by the local oxidization method, for example, to form an isolation film of approximately 3000Å. The U-shaped grooves are extended along the surface, crosswisely isolating entire circumference of each cell block.

Next, polycrystalline silicon is grown in the U-shaped groove 22, by a widely known method, such as CVD (Chemical Vapor Deposition), to form the isolation wall 24. The excessive polycrystalline silicon grown beyond the surface is removed by polishing to form a flat surface. The silicon nitride film 14 is removed by a widely known method, such as chemical etching. The polished surfaces of the polycrystalline silicon and other portions are oxidized by a widely known method, such as a thermal oxidation.

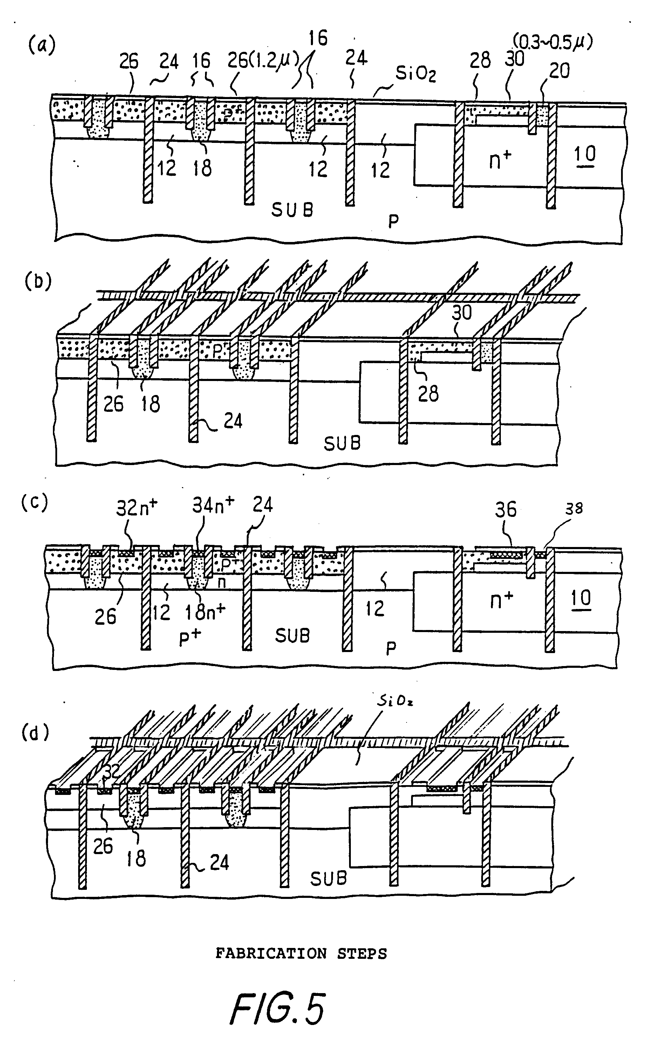

Next, on the specific portion of the n epitaxial layer 12, a $p^+$ dopant, such as boron, is diffused as much as $10^{14}$ cm$^{-2}$ of concentration, for example, to form an approximately 1.2 micron thick $p^+$ layer 26, 28 and an approximately 0.3 to 0.5 micron thick $p^+$ layer 30, as shown in FIG. 5(a), by a widely known method used for a general bipolar IC fabrication process. These $p^+$ layers form the emitter regions of the pnp transistor Q and the base region of the npn transistors of the peripheral circuits. Owing to the existance of the isolation layer 16, self-alignment technique can be employed for diffusing these regions. The self-alignment contributes to achieve greater density of integration without production difficulty.

Next, on each specific portion of the $p^+$ layer 26, 18, 30, an $n^+$ dopant is diffused to form $n^+$ layers 32, 34, and 36 respectively, by a widely known method used for a general bipolar IC fabricaion. The layer 32 is the cathode of the diode D. The layer 34 is the base contact to make a good contact with an external aluminum wirings, which is to be fabricated later. The layer 36 is the emitter of npn transistor of the peripheral circuit. Upon the surface having these layers, aluminum wirings for the connections are patterned by a well known technique used for a general bipolar IC fabrication, as shown in FIG. 2(a). Each base contact 34 is connected to the corresponding word line $W_0$, $W_1$,..., and each cathode 32 is connected to each

corresponding bit line $B_0$, $B_1$,..., as mentioned earlier. Now, a pair of memory cell is finally completed.

The effects of the embodiment of the present invention shall be hereinafter described. The U-shaped isolation groove reduces the width of the isolation groove to 1.4 $\mu$m, eliminating the unnecessary width caused by the prior art, such as the bird beak etc., resulting in reduction of the occupation area by the memory cell. The cell area is reduced from 252 $\mu$m$^2$ to 117 $\mu$m$^2$ i.e. approximately 46 percent. This reduced cell size contributes to reduce stray capacity and inductance of the leads in the cell area.

The elimination of the buried layer $n^+$ for leading out the bases to the outside contributes to the improvement of the PROM in three ways. Firstly, it reduces the stray capacity of the word lines, which was made of a buried layer fully facing the substrate in the prior art. Secondly, it reduces the thickness of the epitaxial layer. Thirdly, the reduced thickness of the epitaxial layer contributes to increase the current amplification factor of the transistors both in the cell and in the peripheral circuits, as well as reduces the surface occupation area of the transistors. These are explained further in detail as follows. Because of the elimination of the buried layer, the upward diffusion of the buried layer is of course nothing, saving 1 $\mu$m in thickness. Accordingly, the thickness of the epitaxial layer 12 can be reduced from 3 $\mu$m to 2 $\mu$m, which is the sum of 1.2 $\mu$m of $p^+$ layer for the diode and 0.7 or 0.8 $\mu$m for the base, without sacrificing the thickness of the base and emitter which is delicately important to keep reliability of the cell for the writing-in process. The thin, only 2 $\mu$m thick, epitaxial layer 12 reduces also the thickness of the epitaxial layer 12 from 2 $\mu$m to 1 $\mu$m at the peripheral region where the upward diffusion of the buried layer 10 is 1 micron thick. Namely, the 1 $\mu$m thick epitaxial layer, the 0.3 to 0.5 $\mu$m thick base region 30, and 0.2 to 0.3 $\mu$m thick emitter 36 can make the width of the lateral diffusion of the emitter narrower than that of the thick epitaxial layer, consequently contributing to the reduction of the occupied surface area of the transistors in the peripheral circuits.

In addition to this fact, at the memory cell the elimination of the buried layer increases the facing area of the substrate SUB, namely the collector, to the emitter 32, as well as decreases the length of the path between the emitter and the collector, more than the prior art structure in which the facing area and the shortest path between the emitter and the collector is obstructed by the existance of the buried layer, which is denoted by BL in FIG. 1(b). This increased facing area as well as decresed path length increases current amplification factor of the pnp transistor Q of the cell. The $h_{FE}$ of the transistor is raised from l.5 to 30, for example. These increased current amplification factor reduces the required base current of the transistor Q, namely the addressing current on the word iine supplied from the D/D circuit.

For a switching operation, the stray capacity must be charged during the transient period from the driver circuit. Therefore, the reduced stray capacity reduces the required charging current supplied from the driver circuit to keep same switching speed. This means that, if the same current is supplied, the charging time is reduced, namely fast switching is achieved. Thus the reduced addressing current and the reduced base current reduce the current load of the peripheral circuit, such as D/D circuit. In other words, this reduced current load contributes to the faster switching operation, and results in a simplified structure of the peripheral circuit as well as in a smaller occupation area of the circuit, namely increased density of integration, and also smaller power consumption and the speed, thus the address time is reduced from 20--25 ns to l0--l5 ns. This simplified small circuit structure reduces the stray capacity again.

Needless to say, the Schottky diode-clamped transistor technique is inherited in the peripheral circuit of the present invention for the high speed operation.

The description was made referring to the case where the substrate is of $p^+$ conduction type, however, $n^+$ conduction type is of course applicable to the substrate according to the circuit requirement.

The many features and advantages of the invention are apparent from the detailed specification and thus, it is intended by the appended claims to cover all such features and advantages of the system.

## Claims

1.  Junction-shortening type semiconductor programmable read only memory device comprising a semiconductor substrate (SUB) of a first conductive type,
    a plurality of first regions (12) of an opposite conductive type to said first conductive type of said substrate (SUB) formed on said substrate (SUB),
    a plurality of word lines ($W_0$, $W_1$,...) as well as a plurality of bit lines ($B_0$, $B_1$,...), and a memory cell (MC) including a transistor and a diode at each cross point of a word line ($W_0$, $W_1$,...) and a bit line ($B_0$, $B_1$,...), characterized in that the memory cells are arranged in pairs forming cell blocks and in that the structure of each memory cell block comprises:
    first dielectric isolation means (24) surrounding one of said first regions (12) and reaching said substrate (SUB);
a second region (18) doped with a dopant of said opposite conductive type into the central area of said first region (12) so as to divide said first region (12) into two divided first regions (12), whereby said second region (18) connects said divided first regions (12) to the word line ($W_1$, $W_2$,....);
a third region (26) of said first conductive type formed on each of said divided first regions (12), but apart from said second region (18);
a fourth region (32) of said opposite conductive type formed on each of said third regions (26);
one of said bit lines ($B_0$, $B_1$,....) connected to said fourth region (32); and
one of said word lines ($W_0$, $W_1$,...) connected to said second region (18);
wherein said substrate (SUB), said divided first region (12) and said third region (26) form the transistor (Q) and said third region (26) and said fourth region (32) form the diode (D) of each of said memory cells.

2.  A memory device according to claim 1, characterized in that said second region (18) is isolated at its two sides from each of said third regions (26) by second dielectric isolation means (16) which does not reach said substrate (SUB).

3.  A memory device according to claim 1 or 2, characterized in that each of said divided first regions (12) is surrounded at three vertical sides by said first dielectric isolation means (24) and is surrounded at its remaining one vertical side facing to the other of the divided first regions by said second dielectric isolation means (16) and said second region (18).

4.  A memory device according to claim 3, characterized in that said second region (18) is surrounded at its two vertical sides facing to each other by said second dielectric isolation means (16) and is surrounded at its remaining two vertical sides by said first dielectric isolation means (24).

5.  A memory device according to any one of claims 1 to 4, characterized in that said first dielectric isolation means (24) is made of a U-shaped groove (22) filled with a dielectric insulating material.

6.  A memory device according to any one of claims 1 to 4, characterized in that said first dielectric isolation means (24) is made of a V-shaped groove filled with a dielectric insulating material.

7. A memory device according to any one of claims 2 to 6, characterized in that said second dielectric isolation means (16) is made by field oxidization.

8. A memory device according to any one of claims 2 to 6, characterized in that said second dielectric isolation means (16) is made of a V-shaped groove filled with a dielectric insulating material.

9. A memory device according to any one of claims 1 to 8, characterized in that said divided first region (12) being a base of said cell transistor (Q), said third region (26) being an emitter of said cell transistor (Q) as well as an anode of said cell diode (D), and said fourth region (32) being a cathode of said cell diode (D).

10. Process for fabricating a junction-shortening type semi-conductor programmable read only memory device according to any one of claims 1 to 9,
in which
after forming a buried layer (10) for forming peripheral circuits on a substrate (SUB) an epitaxial layer (12) is grown all over said substrate (SUB),
next a silicon nitride film (14) is formed on said epitaxial layer (12) and is patterned, next open windows of said silicon nitride film (14) are oxidized or SVG-fabricated to form second isolation means (16), next between said second isolation means a dopant is diffused or ion implantated to form a second region (18), next grooves (22) are formed and filled with an isolation film, next a dopant is diffused on specific portions of said epitaxial layer (12) to form a third region (26),
next on said second and third regions (18, 26) a dopant is diffused to form contacts and a fourth region (32), respectively, and next wirings are connected to the latter region.

**Revendications**

1. Dispositif de mémoire morte programmable à semiconducteur du type à court-circuit de jonction comprenant un substrat semiconducteur (SUB) d'un premier type de conductivité, une pluralité de premières régions (12) d'un type de conductivité opposé audit premier type de conductivité dudit substrat (SUB) formées sur ledit substrat (SUB), une pluralité de fils de mot $(W_0, W_1, ...)$ ainsi qu'une pluralité de fils de bit $(B_0, B_1, ...)$ et une cellule de mémoire incluant un transistor et une diode à chaque point de croisement d'un fil de mot $(W_0, W_1, ...)$ et d'un fil de bit $(B_0, B_1, ...)$ caractérisé en ce que les cellules de mémoire sont disposées en paires constituant des blocs de cellules et en ce que la structure de chaque bloc de cellules de mémoire comprend:
un premier moyen isolant diélectrique (24) entourant une desdites premières régions (12) et atteignant ledit substrat (SUB);
une deuxième région (18) dopée avec un dopant dudit type de conductivité opposé jusque dans la zone centrale de ladite première région (12) de manière à diviser ladite première région (12) en deux premières régions (12) divisées, ladite deuxième région (18) connectant ainsi lesdites premières régions (12) divisées au fil de mot $(W_1, W_2, ...)$;
une troisième région (26) dudit premier type de conductivité formée sur chacune desdites premières régions (12) divisées, mais espacée de ladite deuxième région (18);
une quatrième région (32) dudit type de conductivité opposé formée sur chacune desdites troisièmes régions (26);
un desdits fils de bit $(B_0, B_1, ...)$ étant connecté à ladite quatrième région (32); et
un desdits fils de mot $(W_0, W_1, ...)$ étant connecté à ladite deuxième région (18);
dans lequel ledit substrat (SUB), ladite première région (12) divisée, et ladite troisième région (26) constituent le transistor Q et ladite troisième région (26) et ladite quatrième région (32) constituent la diode (D) de chacune desdites cellules de mémoire.

2. Dispositif de mémoire selon la revendication 1, caractérisé en ce que ladite deuxième région (18) est isolée de ses deux côtés de chacune desdites troisièmes régions (26) par un deuxième moyen isolant diélectrique (16) qui n'atteint pas ledit substrat (SUB).

3. Dispositif de mémoire selon l'une quelconque des revendications 1 et 2, caractérisé en ce que chacune desdites premières régions (12) divisées est entourée de trois côtés verticaux par ledit premier moyen isolant diélectrique (24) et est entourée de son autre côté vertical en face de l'autre des premières régions divisées par ledit deuxième moyen isolant diélectrique (16) et ladite deuxième région (18).

4. Dispositif de mémoire selon la revendication 3, caractérisé en ce que ladite deuxième région (18) est entourée de deux de ses côtés verticaux en face l'un de l'autre par ledit moyen isolant diélectrique (16) et est entourée de ses deux autres côtés verticaux par ledit premier moyen isolant diélectrique (24).

5. Dispositif de mémoire selon l'une quelconque des revendications 1 à 4, caractérisé en ce que ledit premier moyen isolant diélectrique (24) est constitué d'une rainure en forme de U (22) remplie d'un matériau isolant diélectrique.

6. Dispositif de mémoire selon l'une quelconque des revendications 1 à 4, caractérisé en ce que ledit premier moyen isolant diélectrique (24) est constitué d'une rainure en forme de V remplie d'un matériau isolant diélectrique.

7. Dispositif de mémoire selon l'une quelconque des revendications 2 à 6, caractérisé en ce que ledit deuxième moyen isolant diélectrique (16) est réalisé par oxydation de champ.

8. Dispositif de mémoire selon l'une quelconque des revendications 2 à 6, caractérisé en ce que ledit deuxième moyen isolant diélectrique (16) est constitué d'une rainure en forme de V remplie d'un matériau isolant diélectrique.

9. Dispositif de mémoire selon l'une quelconque des revendications 1 à 8, caractérisé en ce que ladite première région (12) divisée est la base dudit transistor de cellule (Q), ladite troisième région (26) est l'émetteur dudit transistor de cellule (Q) ainsi que l'anode de ladite diode de cellule (D), et ladite quatrième région (32) est la cathode de ladite diode de cellule (D).

10. Procédé pour fabriquer un dispositif de mémoire morte programmable à semiconducteur du type à court-circuit de jonction selon l'une quelconque des revendications 1 à 9, dans lequel, après avoir formé une couche enfouie (10) pour la formation de circuits périphériques sur un substrat (SUB), on fait croître une couche épitaxiale (12) sur tout ledit substrat (SUB), on forme ensuite un film de nitrure de silicium (14) sur ladite couche épitaxiale (12) et on lui donne la configuration d'un modèle, on oxyde ensuite des fenêtres ouvertes dans ledit film de nitrure de silicium (14) ou on les fabrique en verre SVG pour former le deuxième moyen isolant (16), on diffuse ensuite entre lesdits deuxièmes moyens isolants un produit dopant ou on implante des ions pour former une deuxième région (18), on forme ensuite des rainures (22) et on les remplit d'un film isolant, on diffuse ensuite un produit dopant sur des parties spécifiques de ladite couche épitaxiale (12) pour former une troisième région (26), on diffuse ensuite un produit dopant sur lesdites deuxième et troisième régions (18,26) pour former des contacts et une quatrième région (32), respectivement, et on connecte ensuite des fils de câblage à la dernière région.

**Patentansprüche**

1. Programmierbare Halbleiter-Nurlese-Speichervorrichtung vom Übergangs-Kurzschlußtyp mit

    einem Halbleitersubstrat (SUB) eines ersten Leitfähigkeitstyps,

    einer Mehrzahl von auf diesem Substrat (SUB) ausgebildeten ersten Regionen (12) mit einem dem ersten Leitfähigkeitstyp des Substrats (SUB) entgegengesetzten Leitfähigkeitstyp,

    und einer Mehrzahl von Wortleitungen ($W_0$, $W_1$, ...) und einer Mehrzahl von Bitleitungen ($B_0$, $B_1$, ...) und einer Speicherzelle (MC) mit einem Transistor und einer Diode an jedem Kreuzungspunkt einer Wortleitung ($W_0$, $W_1$, ...) und einer Bitleitung ($B_0$, $B_1$, ...),

    **dadurch gekennzeichnet,**

    daß die Speicherzellen in Paaren angeordnet sind, die Zellenblöcke bilden,

    und daß die Struktur jedes Speicherzellenblocks folgende Teile aufweist:

    erste dielektrische Isolationsmittel (24), die eine der genannten ersten Regionen (12) umgeben und an das Substrat (SUB) heranreichen,

    eine zweite Region (18), die mit einem Dotierstoff des genannten entgegengesetzten Leitfähigkeitstyps derart in den zentralen Bereich der ersten Region (12) dotiert ist, daß sie die erste Region (12) in zwei unterteilte erste Regionen (12) teilt, so daß die zweite Region (18) die unterteilten ersten Regionen (12) mit der Wortleitung ($W_0$, $W_1$, ...) verbindet,

    eine dritte Region (26) des ersten Leitfähigkeitstyps, die auf jeder der unterteilten ersten Regionen (12), jedoch von der zweiten Region (18) getrennt, ausgebildet ist,

    eine vierte Region (32) des genannten entgegengesetzten Leitfähigkeitstyps, die auf jeder der dritten Regionen (26) ausgebildet ist,

    wobei eine der Bitleitungen ($B_0$, $B_1$, ...) mit der vierten Region (32) und

    eine der Wortleitungen ($W_0$, $W_1$, ...) mit der zweiten Region (18) verbunden ist,

    und wobei das Substrat (SUB), die unterteilte erste Region (12) und die dritte Region (26) den Transistor (Q) und die dritte Region (26) und die vierte Region (32) die Diode (D) jeder der genannten Speicherzellen bilden.

2. Speichervorrichtung nach Anspruch 1, dadurch gekennzeichnet, daß die zweite Region (18) an ihren beiden Seiten von jeder der genannten dritten Regionen (26) durch zweite dielektrische Isolationsmittel (16) isoliert ist, die nicht an das Substrat (SUB) heranreichen.

3. Speichervorrichtung nach Anspruch 1 oder 2, dadurch gekennzeichnet, daß jede der unterteilten ersten Regionen (12) an drei vertikalen Seiten von dem ersten dielektrischen Isolationsmittel (24) und an seiner einen verbleibenden vertikalen Seite, die der anderen der unterteilten ersten Regionen gegenüberliegt, von dem zweiten dielektrischen Isolationsmittel (16) und der zweiten Region (18) umgeben ist.

4. Speichervorrichtung nach Anspruch 3, dadurch gekennzeichnet, daß die zweite Region (18) an ihren beiden einander gegenüberliegenden vertikalen Seiten von dem zweiten dielektrischen Isolationsmittel (16) und an ihren beiden verbleibenden vertikalen Seiten von dem ersten dielektrischen Isolationsmittel (24) umgeben ist.

5. Speichervorrichtung nach einem der Ansprüche 1 bis 4, dadurch gekennzeichnet, daß das erste dielektrische Isolationsmittel (24) aus einer mit einem dielektrischen Isoliermaterial ausgefüllten U-förmigen Nut (22) besteht.

6. Speichervorrichtung nach einem der Ansprüche 1 bis 4, dadurch gekennzeichnet, daß das erste dielektrische Isolationsmittel (24) aus einer mit einem dielektrischen Isoliermaterial ausgefüllten V-förmigen Nut (22) besteht.

7. Speichervorrichtung nach einem der Ansprüche 2 bis 6, dadurch gekennzeichnet, daß das zweite dielektrische Isolationsmittel (16) durch Feldoxidation hergestellt ist.

8. Speichervorrichtung nach einem der Ansprüche 2 bis 6, dadurch gekennzeichnet, daß das zweite dielektrische Isolationsmittel (16) aus einer mit einem dielektrischen Isoliermaterial gefüllten V-förmigen Nut besteht.

9. Speichervorrichtung nach einem der Ansprüche 1 bis 8, dadurch gekennzeichnet, daß die unterteilte erste Region (12) eine Basis des genannten Zellen-Transistors (Q) bildet, daß die dritte Region (26) einen Emitter des Zellen-Transistors (Q) und eine Anode der Zellen-Diode (D) bildet und daß die vierte Region (32) eine Kathode der Zellen-Diode (D) bildet.

10. Verfahren zur Herstellung einer programmierbaren Halbleiter-Nurlese-Speichervorrichtung vom Übergangs-Kurzschlußtyp nach einem der Ansprüche 1 bis 9, bei dem

man nach der Ausbildung einer vergrabenen Schicht (10) zur Herstellung peripherer Schaltungen auf einem Substrat (SUB) eine epitaxiale Schicht (12) auf dem ganzen Substrat (SUB) aufwachsen läßt,

als nächstes ein Silizium-Nitrid-Film (14) auf der epitaxialen Schicht (12) ausgebildet und mit Mustern versehen wird, dann offene Fenster diesem Silizium-Nitrid-Film (14) oxidiert werden oder mit flachen V-förmigen Isolationsnuten (SVG) versehen werden, um zweite Isolationsmittel (16) zu bilden,

als nächstes zwischen dem zweiten Isolationsmittel ein Dotierstoff diffundiert oder ionenimplantiert wird, um eine zweite Region (18) zu bilden,

als nächstes Nuten (22) ausgebildet und mit einem Isolationsfilm gefüllt werden,

als nächstes ein Dotierstoff auf spezifischen Abschnitten der epitaxialen Schicht (12) diffundiert wird, um eine dritte Region (26) zu bilden,

als nächstes auf der zweiten und der dritten Region (18, 26) ein Dotierstoff diffundiert wird, um Kontakte bzw. eine vierte Region (32) zu bilden, und

als nächstes Verdrahtungen mit der letztgenannten Region verbunden werden.

PRIOR ART

*FIG.1*

(a) BIRDS-EYE VIEW

(b) CIRCUIT DIAGRAM

(c) PLAN VIEW OF SIX CELL BLOCKS

MEMORY CELLS ACCORDING TO THE INVENTION

FIG.2

MEMORY CELL ←—|—→ PERIPHERAL CIRCUIT

(a)

14 Si₃N₄ (1000Å)

12   n (2μ)

10   n⁺

SUB   P⁺

(b)

14   16   16   20 n⁺

18   18   12   n   10   n⁺

n⁺   n⁺   SUB   P⁺

(c)

16   16

14   14

12   n   10   n⁺

SUB   P⁺

FABRICATION STEPS

*FIG.3*

13

(a)

CHANNEL CUT

(b)

FABRICATION STEPS

*FIG.4*

14

FABRICATION STEPS

*FIG.5*

UPWARD DIFFUSION FOR BASE CONTACT

FIG.6